# EUROPEAN PATENT SPECIFICATION

(11) **EP 3 067 937 B1**
(45) Date of publication and mention of the grant of the patent: **06.01.2021**
(21) Application number: 16159847.9
(22) Date of filing: 11.03.2016
(51) Int. Cl.: H01L 31/05, H01L 31/054

(54) **SOLAR CELL MODULE**
SOLARZELLENMODUL
MODULE DE CELLULE SOLAIRE

(30) Priority: 13.03.2015 JP 2015050913; 31.08.2015 JP 2015171577
(43) Date of publication of application: 14.09.2016
(73) Proprietor: Panasonic Intellectual Property Management Co., Ltd., Osaka-shi, Osaka 540-6207 (JP)
(72) Inventor: OGAWA, Keisuke, Osaka 540-6207 (JP); MURAKAMI, Youhei, Osaka 540-6207 (JP); IWATA, Masahiro, Osaka 540-6207 (JP); KANNO, Hiroshi, Osaka 540-6207 (JP); MAEKAWA, Akimichi, Osaka 540-6207 (JP)
(74) Representative: Glawe, Delfs, Moll

(56) References cited:
- EP-A1- 2 677 554
- EP-A2- 2 897 179
- WO-A1-2012/114918
- US-A1- 2009 178 704
- US-A1- 2010 108 123
- US-A1- 2012 118 352
- US-A1- 2013 298 965

## Description

### BACKGROUND OF THE INVENTION

### 1. Field of the Invention

This disclosure relates to a solar cell module.

### 2. Description of the Related Art

There has heretofore been advanced the development of solar cell modules as a photoelectric converter to convert light energy into electric energy. The solar cell module can convert inexhaustible sunlight directly into electric power, and is environment-friendly and clean compared with power generation with a fossil fuel. Thus, the solar cell module has been considered promising as a new energy source.

The solar cell module has a structure in which solar cells are sealed by a bonding layer between a front protective member and a back protective member, for example. In the solar cell module, the solar cells are arranged in a matrix pattern. There has heretofore been proposed a solar cell module in which in order to effectively utilize sunlight irradiated onto the gap between solar cells, a light reflection member is provided in a gap between the solar cells, the light reflection member protruding from light-receiving surfaces of the solar cells and having top surfaces tilting to the light-receiving surfaces, (for example, Japanese Patent Application Publication No. 2013-98496).

US 2013/298965 refers to a solar module, which includes a back plate, a reflecting structure, one or more solar cell units, a bottom sealant, a top sealant, and a transparent plate. The reflecting structure is disposed on the back plate. The reflecting structure has inclines and a reflector layer. The solar cell units are disposed on the back plate.

US 2009/178704 A1 discloses a solar electric module having a layered construction including a light redirection layer and light transmitting materials that encapsulate the solar cells of the module.

WO 2012/114918 A1 relates to a solar cell module provided with a resin layer, a solar cell, and a wraparound suppression member. The resin layer has a colored resin layer and a transparent resin layer disposed on the colored resin layer. The solar cell is disposed between the colored resin layer and the transparent resin layer in a manner so that the rear surface of the solar cell faces the colored resin layer side, and the light receiving surface faces the transparent resin layer side.

### SUMMARY OF THE INVENTION

When the light reflection member has a conductive light reflection film such as a metal film, there is a problem that leak current is generated between solar cells through the conductive light reflection film if the light reflection member is disposed in a gap between the solar cells.

It is an object of the invention to provide a solar cell module capable of suppressing generation of a leak current even when a light reflection member having a conductive light reflection film is disposed between solar cells.

This object is achieved by a solar cell module according to claim 1; the dependent claims are related to further developments of the invention.

According to the invention, the generation of a leak current can be suppressed even when the light reflection member having the conductive light reflection film is disposed between the solar cells.

### BRIEF DESCRIPTION OF THE DRAWINGS

Fig. 1A is a plan view of a solar cell module according to Embodiment 1 (not forming part of the present invention).
Fig. 1B is a cross-sectional view taken along the line IB-IB in Fig. 1A, illustrating the solar cell module according to Embodiment 1 (not forming part of the present invention).
Fig. 2A is a partially enlarged plan view of the solar cell module according to Embodiment 1 (not forming part of the present invention).
Fig. 2B is a cross-sectional view (enlarged cross-sectional view around a light reflection member) taken along the line IIB-IIB in Fig. 2A, illustrating the solar cell module according to Embodiment 1 (not forming part of the present invention) .
Fig. 3 is a partially enlarged cross-sectional view of a solar cell module of a comparative example.
Fig. 4 is a partially enlarged cross-sectional view of a solar cell module according to a modified example of Embodiment 1 (not forming part of the present invention).
Fig. 5A is an enlarged cross-sectional view around a light reflection member in a solar cell module according to Embodiment 2 (not forming part of the present invention).
Fig. 5B is an enlarged cross-sectional view around a light reflection member in the solar cell module according to Embodiment 2 (not forming part of the present invention).
Fig. 6 is a partially enlarged cross-sectional view of a solar cell module according to a modified example of Embodiment 2 (not forming part of the present invention).
Fig. 7 is an enlarged cross-sectional view around a light reflection member in a solar cell module according to Embodiment 3 (not forming part of the present invention).
Fig. 8 is a partially enlarged cross-sectional view of a solar cell module according to a modified example of Embodiment 3 (not forming part of the present invention).
Fig. 9 is an enlarged cross-sectional view around a light reflection member in a solar cell module according to Embodiment 4 (not forming part of the present invention).
Fig. 10 is an enlarged cross-sectional view around a light reflection member in a solar cell module according to Modified Example 1 of Embodiment 4 according to the present invention.
Fig. 11A is an enlarged cross-sectional view around a light reflection member in the solar cell module according to Embodiment 4 illustrated in Fig. 9 (not forming part of the present invention).
Fig. 11B is an enlarged cross-sectional view around the light reflection member in the solar cell module according to Modified Example 1 of Embodiment 4 illustrated in Fig. 10 according to the present invention.
Fig. 12A is a partially enlarged cross-sectional view of another aspect of the solar cell module according to Modified Example 1 of Embodiment 4 illustrated in Fig. 10 according to the present invention.
Fig. 12B is a partially enlarged back view of another aspect of the solar cell module according to Modified Example 1 of Embodiment 4 illustrated in Fig. 10 according to the present invention.
Fig. 13 is a partially enlarged cross-sectional view of a solar cell module according to Modified Example 2 of Embodiment 3 (not forming part of the present invention).
Fig. 14 is a partially enlarged cross-sectional view of a solar cell module according to Modified Example 3 of Embodiment 3 according to the present invention.
Fig. 15 is a partially enlarged cross-sectional view of a solar cell module according to Modified Example 1 (not forming part of the present invention).
Fig. 16 is a partially enlarged cross-sectional view of a solar cell module according to Modified Example 2 according to the invention.
Fig. 17 is a partially enlarged cross-sectional view of a solar cell module according to Modified Example 3 according to the present invention).
Fig. 18 is a partially enlarged cross-sectional view of a solar cell module according to Modified Example 4 (not forming part of the present invention).

### DESCRIPTION OF THE PREFERRED EMBODIMENTS

With reference to the drawings, embodiments of the invention and embodiments not forming part of the invention are described below. Therefore, numerical values, shapes, materials, constituent elements, arrangement positions and the connection configuration of the constituent elements, steps, the order of the steps, and the like described in the following embodiments are merely examples, and are not intended to limit the invention. Therefore, among the constituent elements in the following embodiments, constituent elements that are not described in independent claims that show the most superordinate concept of the invention are described as optional constituent elements.

Note that the drawings are schematic and not necessarily to scale. Also, in the drawings, substantially the same elements are denoted by the same reference numerals, and repetitive description is omitted or simplified.

### (Embodiment 1)

### [Configuration of Solar Cell Module]

### (Example 1)

### [Configuration of Solar Cell Module]

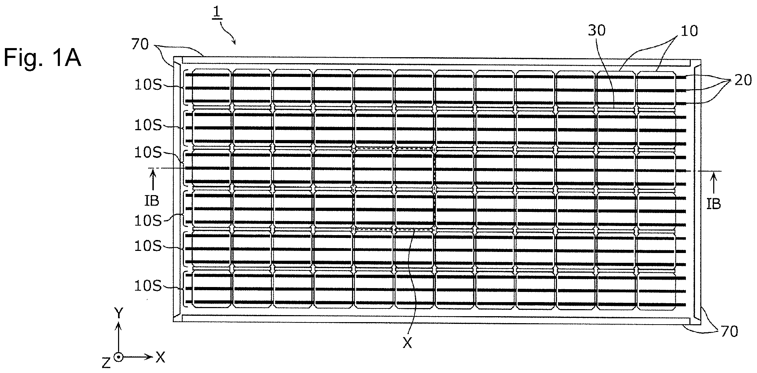

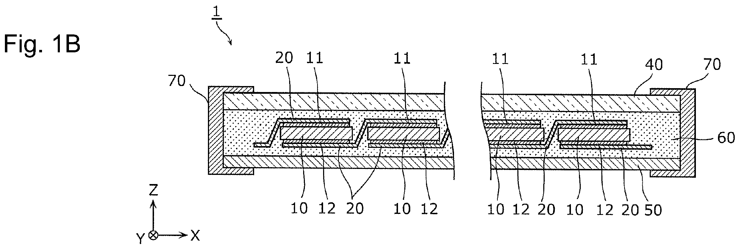

First, with reference to Figs. 1A and 1B, description is given of a schematic configuration of solar cell module 1 according to Example 1. Fig. 1A is a plan view of the solar cell module according to Example 1. Fig. 1B is a cross-sectional view taken along the line IB-IB in Fig. 1A, illustrating the solar cell module according to Example 1.

Note that, in Figs. 1A and 1B, the Z-axis is perpendicular to the principal surface of solar cell module 1, and the X-axis and Y-axis are orthogonal to each other and also are both orthogonal to the Z-axis (the thickness direction of the solar cells). As for the Z-axis, X-axis and Y-axis, the same applies to the following drawings.

As illustrated in Figs. 1A and 1B, solar cell module 1 includes solar cells 10, tab wiring members 20, light reflection member 30, front protective member 40, back protective member 50, bonding layer 60 and frame 70. Solar cell module 1 has a structure in which solar cells 10 are sealed between front protective member 40 and back protective member 50 by bonding layer 60.

As illustrated in Fig. 1A, solar cell module 1 has an approximately rectangular shape, for example, in a planar view. As an example, solar cell module 1 has an approximately rectangular shape that is about 1600 mm in width and about 800 mm in length. Note that the shape of solar cell module 1 is not limited to a rectangular shape.

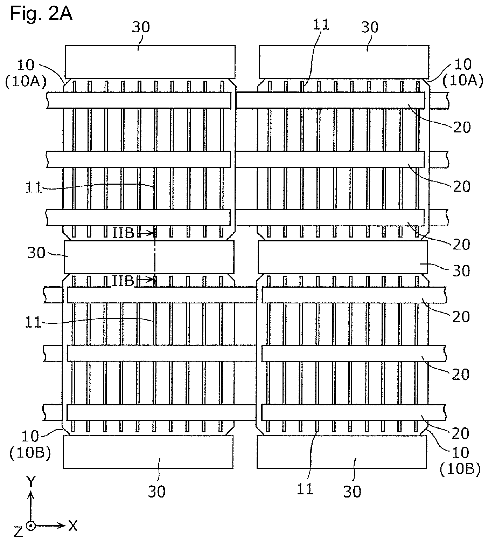

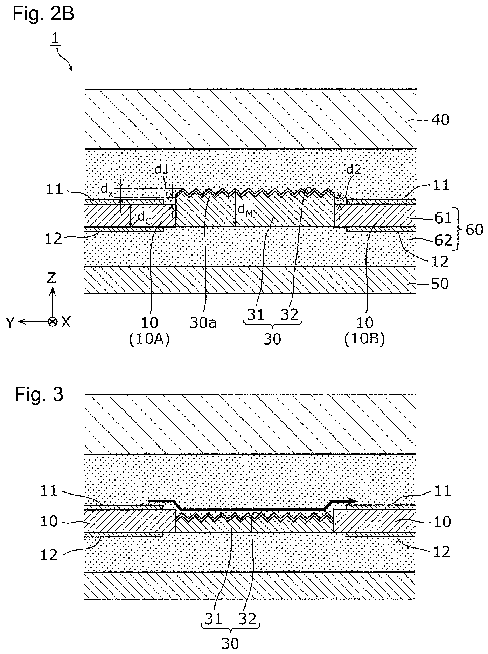

The constituent members in solar cell module 1 are described in more detail with Figs. 2A and 2B while referring to Figs. 1A and 1B. Fig. 2A is an enlarged view of Region X surrounded by the broken line in Fig. 1A, and is a partially enlarged plan view of the solar cell module according to Example 1. Fig. 2B is a cross-sectional view taken along the line IIB-IIB in Fig. 2A, illustrating the solar cell module according to Example 1. Note that Fig. 2B is an enlarged cross-sectional view around light reflection member 30.

### [Solar Cell (Solar Cell Element)]

Solar cells 10 are photoelectric conversion elements (photovoltaic elements), which convert light such as sunlight into electric power. As illustrated in Fig. 1A, solar cells 10 are arranged in a line-column pattern (matrix) in the same plane.

As for solar cells 10 linearly arranged along one of a row direction and a column direction, two solar cells 10 adjacent to each other are connected by tab wiring members 20 to form a string (cell string). Multiple solar cells 10 are electrically connected by tab wiring members 20 to form a string. Solar cells 10 in one string 10S are connected in series by tab wiring members 20.

In this embodiment, as illustrated in Fig. 1A, twelve solar cells 10 arranged equally spaced apart along the row direction (X-axis direction) or a first direction are connected by tab wiring members 20 to form one string 10S. To be more specific, each string 10S is formed by sequentially connecting two solar cells 10 adjacent to each other in the row direction (X-axis direction) with three tab wiring members 20. All solar cells 10 in a line arranged along the row direction are connected.

Strings 10S are formed in multiple numbers. Strings 10S (strings) are arranged along the other one of the row direction and the column direction. In this embodiment, six strings 10S are formed. As illustrated in Fig. 1A, six strings 10S are arranged equally spaced apart along the column direction (Y-axis direction) or a second direction so as to be parallel to each other.

Note that the first solar cell 10 in each string 10S is connected to an interconnection wiring member (not illustrated) through tab wiring members 20. Likewise, the last solar cell 10 in each string 10S is connected to an interconnection wiring member (not illustrated) through tab wiring members 20. Thus, more than one string 10S (six strings in Fig. 1A) is connected in series or connected in parallel to form a cell array. In this embodiment, two strings 10S adjacent to each other are connected in series to form one series connection body (twenty-four series-connected solar cells 10), and three series connection bodies are connected in parallel.

As illustrated in Figs. 1A and 2A, solar cells 10 are arranged with a gap between solar cells 10 adjacent to each other in the row direction and column direction. As described later, light reflection member 30 is disposed in the gap.

In this embodiment, solar cell 10 has an approximately rectangular shape in a planar view. To be more specific, solar cell 10 has a 125×125 mm square shape with chamfered corners. That is, one string 10S is configured such that two solar cells 10 adjacent to each other have their one sides facing each other. Note that the shape of solar cell 10 is not limited to the approximately rectangular shape.

Solar cell 10 has a semiconductor pin junction as a basic structure. As an example, solar cell 10 includes: an n-type single crystal silicon substrate, which is an n-type semiconductor substrate; an i-type amorphous silicon layer, an n-type amorphous silicon layer and an n-side surface electrode, which are sequentially formed on one principal surface side (front side) of the n-type single crystal silicon substrate; and an i-type amorphous silicon layer, a p-type amorphous silicon layer and a p-side surface electrode, which are sequentially formed on the other principal surface side (back side) of the n-type single crystal silicon substrate. The n-side surface electrode and the p-side surface electrode are transparent electrodes made of ITO (Indium Tin Oxide) or the like, for example. Note that, since solar cell module 1 in this embodiment is of a single-sided light receiving type, the p-side surface electrode does not have to be transparent but may be a reflective metal electrode, for example.

In solar cell 10, as illustrated in Figs. 1B and 2B, front-side collector electrode 11 (n-side collector electrode), which is electrically connected to the n-side surface electrode in solar cell 10, and back-side collector electrode 12 (p-side collector electrode), which is electrically connected to the p-side surface electrode in solar cell 10, are formed.

For example, each of front-side collector electrode 11 and back-side collector electrode 12 includes: finger electrodes linearly formed so as to be orthogonal to the extending direction of tab wiring members 20; and bus bar electrodes connected to the finger electrodes and linearly formed along a direction orthogonal to the finger electrodes (the extending direction of tab wiring members 20). The number of the bus bar electrodes is the same as that of tab wiring members 20, for example, and is three in this embodiment. Note that front-side collector electrode 11 and back-side collector electrode 12 have the same shape, but the invention is not limited thereto.

Front-side collector electrode 11 and back-side collector electrode 12 are made of a low-resistance conductive material such as silver (Ag). For example, front-side collector electrode 11 and back-side collector electrode 12 can be formed by screen printing conductive paste (silver paste or the like) in a predetermined pattern on the n-side surface electrode and the p-side surface electrode, the conductive paste having a conductive filler such as silver dispersed in binder resin.

In solar cell 10 thus configured, both of the front surface (n-side surface) and the back surface (p-side surface) serve as light-receiving surfaces. When light enters solar cell 10, carriers are generated in a photoelectric conversion body in solar cell 10. The generated carriers diffuse into the n-side surface electrode and the p-side surface electrode as a photocurrent, and then are collected by front-side collector electrode 11 and back-side collector electrode 12 before flowing into tab wiring members 20. By providing front-side collector electrode 11 and back-side collector electrode 12 as described above, the carriers generated in solar cell 10 can be efficiently taken out to an external circuit.

### [Tab Wiring Member]

As illustrated in Figs. 1A and 1B, tab wiring member 20 (interconnector) electrically connects two adjacent solar cells 10 to each other in string 10S. In this embodiment, as illustrated in Figs. 1A and 2A, two adjacent solar cells 10 are connected by three tab wiring members 20 disposed approximately parallel to each other. Tab wiring members 20 are provided so as to extend along the arrangement direction of two solar cells 10 to be connected.

Each of tab wiring members 20 is an elongated conductive wiring member, and is a ribbon-shaped metal foil, for example. Tab wiring member 20 can be fabricated, for example, by cutting a metal foil, such as a copper foil and a silver foil, with its entire surface covered with solder, silver or the like into rectangles each having a predetermined length.

As illustrated in Fig. 1B, each of tab wiring members 20 has one end thereof disposed on the front surface of one of two adjacent solar cells 10, and the other end disposed on the back surface of the other one of two adjacent solar cells 10.

Each of tab wiring members 20 electrically connects the n-side collector electrode (front-side collector electrode) in one solar cell 10 to the p-side collector electrode (back-side collector electrode) in the other solar cell 10, as for two adjacent solar cells 10. To be more specific, tab wiring member 20 is connected to the bus bar electrode of front-side collector electrode 11 in one solar cell 10 and the bus bar electrode of back-side collector electrode 12 in the other solar cell 10. Tab wiring member 20 and front-side collector electrode 11 (back-side collector electrode 12) are bonded by thermocompression bonding with a conductive adhesive, for example, sandwiched therebetween.

Note that tab wiring member 20 and front-side collector electrode 11 (back-side collector electrode 12) may be bonded not with the conductive adhesive but with a solder material.

Moreover, tab wiring member 20 may have unevenness provided on its surface. When the light entering solar cell module 1 is made incident on the surface of tab wiring member 20, the unevenness provided on the surface of tab wiring member 20 scatters the light to be reflected on an interface between front protective member 40 and an air layer or an interface between front protective member 40 and bonding layer 60, thus enabling the light to be guided to solar cells 10. This enables the light reflected by the surface of tab wiring member 20 to effectively contribute to power generation. As a result, power generation efficiency of solar cell module 1 is improved.

As tab wiring member 20 described above, one having a silver deposited film formed on the surface of copper foil having unevenness as a surface shape can be used. Note that tab wiring member 20 may have a flat surface rather than such an uneven shape. Moreover, a light reflection member having an uneven surface may be additionally laminated on a tab wiring member having a flat surface.

### [Light Reflection Member]

As illustrated in Figs. 1A, 2A and 2B, light reflection member 30 is provided in solar cell 10. Light reflection member 30 is at least partially positioned on a side of solar cell 10. As illustrated in Fig. 2B, in this embodiment, light reflection member 30 is provided between two adjacent solar cells 10 (first solar cell 10A and second solar cell 10B) disposed with a gap therebetween.

Moreover, as illustrated in Fig. 1A, more than one light reflection member 30 is provided along a longitudinal direction of string 10S in a gap between two adjacent strings 10S. To be more specific, in the gap between strings 10S, light reflection members 30 are provided in every gap between two solar cells 10.

As illustrated in Fig. 2A, each of light reflection members 30 is a tape-shaped light reflection sheet extending in the longitudinal direction of string 10S, and has an elongated rectangular shape and a thin plate shape, as an example. Light reflection member 30 has a length of 100 mm to 130 mm and a width of 1 mm to 20 mm, for example.

Each light reflection member 30 covers the gap between two adjacent solar cells 10. That is, the width of light reflection member 30 is the same as the distance of the gap between two adjacent solar cells 10. Note that the width of light reflection member 30 is not limited thereto but may be smaller than the distance of the gap between two adjacent solar cells 10, for example.

Light made incident on light reflection member 30 is reflected. Light reflection member 30 in this embodiment diffuses and reflects the incident light and thus functions as a light diffusion reflection member. That is, light reflection member 30 is a light diffusion reflection sheet.

As illustrated in Fig. 2B, light reflection member 30 includes: insulating member 31 made of an insulating material; and conductive light reflection film 32 formed on the surface of insulating member 31. That is, light reflection member 30 has a laminated structure of insulating member 31 and conductive light reflection film 32.

Insulating member 31 is made of an insulating resin material such as polyethylene terephthalate (PET) or acrylic, for example. Meanwhile, conductive light reflection film 32 is a metal reflective film made of metal such as aluminum or silver, for example. In this embodiment, conductive light reflection film 32 is an aluminum deposited film.

Moreover, unevenness 30a is formed on the surface of insulating member 31. Conductive light reflection film 32 made of a metal film is formed on the surface of unevenness 30a by vapor deposition or the like, for example. Therefore, conductive light reflection film 32 has uneven surface shape along with the uneven shape of unevenness 30a. The uneven shape of conductive light reflection film 32 enables light made incident on light reflection member 30 to be diffused and reflected in a predetermined direction.

As for unevenness 30a, for example, the height between the concave (valley) and convex (mountain) is 5 µm to 100 µm, and the interval (pitch) between adjacent convexes is 20 µm to 400 µm. In this embodiment, the height between the concave and convex is 12 µm, and the interval (pitch) between adjacent convexes is 40 µm.

Moreover, in this embodiment, light reflection member 30 is disposed such that the surface of conductive light reflection film 32 faces front protective member 40. That is, light reflection member 30 is disposed such that insulating member 31 is positioned on the back protective member 50 side and the surface (back surface) of conductive light reflection film 32 on the solar cell 10 side is positioned on the front protective member 40 side. Note that, in this embodiment, since conductive light reflection film 32 is disposed on the front protective member 40 side, the material of insulating member 31 may be any of a translucent or transparent material such as a transparent material and a non-transparent material such as a white material and a black material.

By providing light reflection member 30 in the gap between two adjacent solar cells 10 as described above, when light entering solar cell module 1 is made incident on the surface of light reflection member 30, the uneven shape of conductive light reflection film 32 diffusely reflects (scatters) the light. The diffusely-reflected light is reflected on the interface between front protective member 40 and the air layer or the interface between front protective member 40 and bonding layer 60, and then guided to solar cells 10. This enables even light entering a region in a gap between two adjacent solar cells 10, which is an ineffective region (in this embodiment, a region in a gap between two adjacent strings 10S, i.e., a region where the incident light cannot contribute to power generation) to effectively contribute to power generation. As a result, the power generation efficiency of solar cell module 1 is improved.

Particularly, in this embodiment, light reflection member 30 is provided not on back protective member 50 or the like, but in a power generation ineffective region at the edge of solar cell 10. Thus, productivity is improved and power generation capacity of solar cell 10 can be efficiently utilized.

Moreover, as illustrated in Fig. 2B, the thickness d_{M} of light reflection member 30 is larger than the thickness dc of solar cell 10 (d_{M} > dc). In this embodiment, the thickness d_{M} of light reflection member 30 is the total thickness including the thickness of insulating member 31 and the thickness of conductive light reflection film 32.

Furthermore, conductive light reflection film 32 of light reflection member 30 is positioned outside the surface of solar cell 10. To be more specific, light reflection member 30 is configured such that conductive light reflection film 32 is positioned outside front-side collector electrode 11 in a direction away from solar cell 10. Therefore, d_{M} - dx > dc is established, where dx is the height of the unevenness of conductive light reflection film 32.

In this embodiment, the thickness dc of solar cell 10 is about 200 µm. Also, the height of the unevenness of conductive light reflection film 32 is 5 µm to 100 µm. In this case, a value (d_{M} - dx) obtained by subtracting the height of the unevenness of conductive light reflection film 32 from the thickness of light reflection member 30 may be set to 200 µm or more, e.g., 250 µm to 500 µm.

Note that the thickness d_{M} of light reflection member 30 is preferably larger by 55 µm or more than a sum of the thickness dc of solar cell 10 and the height dx of the unevenness of conductive light reflection film 32.

Furthermore, as illustrated in Fig. 2B, an added distance (d1+d2) that is a sum of a distance d1 between first solar cell 10A and conductive light reflection film 32 and a distance d2 between second solar cell 10B and conductive light reflection film 32 is preferably 110 µm or more.

Light reflection member 30 thus configured is sealed by bonding layer 60. That is, light reflection member 30 is bonded and fixed by bonding layer 60.

Note that, in this embodiment, the shape of unevenness 30a in light reflection member 30 is a triangular groove shape along the longitudinal direction of light reflection member 30. However, the invention is not limited thereto, but the shape thereof may be a conical shape, a quadrangular pyramid shape, a polyangular pyramid shape, a combination thereof or the like, as long as the shape can scatter light.

### [Front Protective Member and Back Protective Member]

Front protective member 40 (first protective member) is a member configured to protect the front surface of solar cell module 1, and protects the inside (solar cells 10 and the like) of solar cell module 1 from the external environment such as weather and external impact. As illustrated in Fig. 1B, front protective member 40 is provided on the front side (n-side) of solar cell 10, and protects the front-side light receiving surface of solar cell 10.

Front protective member 40 includes a transparent member that transmits light in a wavelength band used for photoelectric conversion in solar cell 10. Front protective member 40 is, for example, a glass substrate (transparent glass substrate) made of a transparent glass material or a resin substrate made of a film-shaped or plate-shaped transparent and water-impervious hard resin material.

On the other hand, back protective member 50 (second protective member) is a member configured to protect the back surface of solar cell module 1, and protects the inside of solar cell module 1 from the external environment. As illustrated in Fig. 1B, back protective member 50 is provided on the back side (p-side) of solar cell 10.

Back protective member 50 is a film-shaped or plate-shaped resin sheet made of a resin material such as polyethylene terephthalate (PET) and polyethylene naphthalate (PEN), for example.

Since solar cell module 1 in this embodiment is of the single-sided light receiving type, back protective member 50 may be a non-transparent plate body or film. In this case, a non-transparent member (light blocking member) may be used as back protective member 50, such as a black member or a laminated film such as a resin film having metal foil such as aluminum foil therein. Note that back protective member 50 is not limited to the non-transparent member but may be a transparent member such as a glass sheet or a glass substrate made of a glass material.

Bonding layer 60 is provided between front protective member 40 and back protective member 50. Front protective member 40 and back protective member 50 are bonded and fixed to solar cells 10 by bonding layer 60.

### [Bonding layer]

Bonding layer (filler material) 60 is disposed between front protective member 40 and back protective member 50. In this embodiment, bonding layer 60 is provided to fill a space between front protective member 40 and back protective member 50.

As illustrated in Fig. 2B, bonding layer 60 includes front-side bonding layer 61 and back-side bonding layer 62. Solar cells 10 are entirely covered with bonding layer 60 by performing lamination (laminate processing) in a state where the solar cells are sandwiched between sheet-like front-side bonding layer 61 and back-side bonding layer 62, for example.

To be more specific, after strings 10S are formed by connecting solar cells 10 with tab wiring members 20, strings 10S are sandwiched between front-side bonding layer 61 and back-side bonding layer 62. Then, front protective member 40 and back protective member 50 are further disposed thereabove and therebelow, and thermocompression bonding is performed in a vacuum at a temperature of 100°C or more, for example. This thermocompression bonding heats and melts front-side bonding layer 61 and back-side bonding layer 62 to form bonding layer 60 that seals solar cells 10.

Front-side bonding layer 61 is a resin sheet made of a resin material such as ethylene-vinyl acetate (EVA), for example, and is disposed between solar cells 10 and front protective member 40. The front-side bonding layer is mainly provided so as to fill a space between solar cells 10 and front protective member 40 by laminate processing. For example, front-side bonding layer 61 is a transparent resin sheet. As an example, front-side bonding layer 61 is a transparent resin sheet made of a hot-melt adhesive of EVA.

Back-side bonding layer 62 is a resin sheet made of a resin material such as ethylene-vinyl acetate (EVA), for example, and is disposed between solar cells 10 and back protective member 50 . Back-side bonding layer 62 is mainly provided so as to fill a space between solar cells 10 and back protective member 50 by laminate processing. Note that, since solar cell module 1 in this embodiment is of the single-sided light receiving type, a black or white resin sheet is used as back-side bonding layer 62. However, the invention is not limited thereto. As an example, back-side bonding layer 62 is a white resin sheet made of a hot-melt adhesive of EVA.

### [Frame]

Frame 70 is an outer frame that covers the peripheral edge of solar cell module 1. Frame 70 is an aluminum frame made of aluminum, for example. As illustrated in Fig. 1A, four frames 70 are used and attached to the four sides of solar cell module 1, respectively. Frames 70 are fixed to the respective sides of solar cell module 1 with an adhesive, for example.

Note that, although not illustrated, solar cell module 1 is provided with a terminal box to take out power generated by solar cells 10. The terminal box is fixed to back protective member 50, for example. The terminal box includes circuit components mounted on a circuit board.

### [Advantageous Effects and the like]

Next, advantageous effects of solar cell module 1 according to this embodiment are described in comparison to solar cell module 1A according to a comparative example. Fig. 3 is a partially enlarged cross-sectional view of the solar cell module according to the comparative example.

As illustrated in Fig. 3, in solar cell module 1A of the comparative example, light reflection member 30 is disposed in a gap between two adjacent solar cells 10, as in the case of solar cell module 1 according to this embodiment.

However, solar cell module 1A of the comparative example is different from solar cell module 1 according to this embodiment in that the thickness of light reflection member 30 is smaller than that of solar cell 10. Therefore, in solar cell module 1A of the comparative example, a leak current may be generated between solar cells 10 through conductive light reflection film 32 of light reflection member 30.

Particularly, solar cell 10 is made of a semiconductor material, and thus the semiconductor material may be present in a side portion of solar cell 10. In this case, if the thickness of light reflection member 30 is smaller than that of solar cell 10, a leak current is generated between solar cells 10 through conductive light reflection film 32 of light reflection member 30.

On the other hand, as illustrated in Fig. 2B, in solar cell module 1 according to this embodiment, the thickness d_{M} of light reflection member 30 is larger than the thickness dc of solar cell 10, and the surface of conductive light reflection film 32 on the solar cell 10 side is positioned outside the surface of solar cell 10 (on the front protective member 40 side).

Accordingly, conductive light reflection film 32 of light reflection member 30 can be spaced from the surface of solar cell 10. Thus, the generation of the leak current can be effectively suppressed. As a result, reliability of solar cell module 1 is improved.

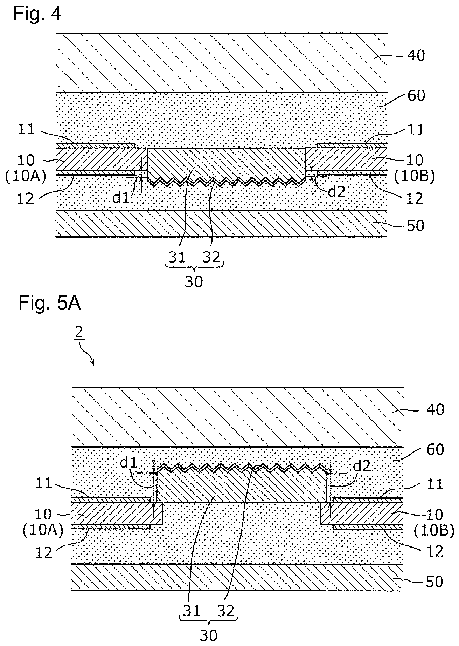

Moreover, in this embodiment, light reflection member 30 is disposed such that the surface of conductive light reflection film 32 faces front protective member 40. However, as illustrated in Fig. 4, light reflection member 30 may be disposed such that the surface of conductive light reflection film 32 faces back protective member 50. That is, light reflection member 30 may be disposed such that insulating member 31 is positioned on the front protective member 40 side and conductive light reflection film 32 is positioned on the back protective member 50 side. In this case, again, the thickness of light reflection member 30 is larger than the thickness dc of solar cell 10, and the surface of conductive light reflection film 32 on the solar cell 10 side is positioned outside the surface of solar cell 10 (on the back protective member 50 side). Thus, the generation of the leak current can be suppressed.

Moreover, it is preferable that the thickness d_{M} of light reflection member 30 is larger by 55 µm or more than a sum of the thickness dc of solar cell 10 and the height dx of the unevenness of conductive light reflection film 32.

From the viewpoint of further ensuring the reliability of solar cell module 1, adjacent solar cells 10 are required to be resistant to application of an impulse voltage of 800 V, for example. In order to achieve such resistance, it is preferable that an insulating distance of 110 µm or more is ensured between adjacent solar cells 10. That is, the insulating distance of 110 µm or more can be ensured between adjacent solar cells 10 by setting the thickness d_{M} of light reflection member 30 to be larger by 55 µm or more than the sum of the thickness dc of solar cell 10 and the height dx of the unevenness of conductive light reflection film 32. Accordingly, also for the application of the impulse voltage, the generation of the leak current due to breakdown can be effectively suppressed. As a result, the reliability of solar cell module 1 is further improved.

Furthermore, as illustrated in Fig. 2B, it is preferable that the added distance (d1 + d2) that is the sum of the distance d1 between first solar cell 10A and conductive light reflection film 32 and the distance d2 between second solar cell 10B and conductive light reflection film 32 is 110 µm or more. Thus, the insulating distance of 110 µm or more is ensured between first solar cell 10A and second solar cell 10B. Thus, also for the application of the impulse voltage, the generation of the leak current due to breakdown can be surely suppressed.

Note that light reflection member 30 illustrated in Fig. 4 has conductive light reflection film 32 on the back protective member 50 side. Therefore, insulating member 31 may include a translucent member such as a transparent member.

### (Embodiment 2)

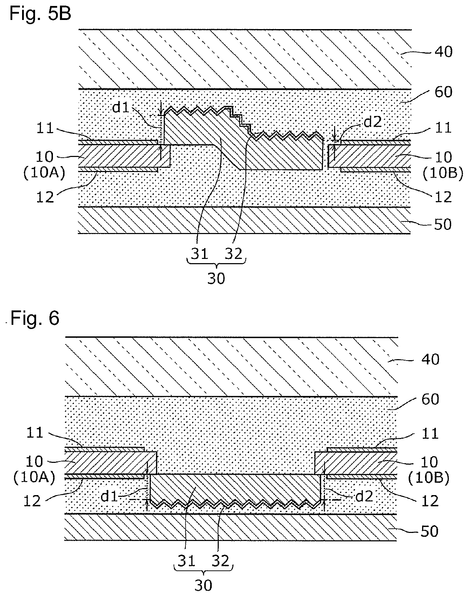

Next, with reference to Figs. 5A and 5B, solar cell module 2 according to Embodiment 2 is described. Figs. 5A and 5B are enlarged cross-sectional views around a light reflection member in the solar cell module according to Embodiment 2.

As illustrated in Fig. 5A, in solar cell module 2 according to this embodiment, light reflection member 30 is provided so as to extend beyond a gap between two adjacent solar cells 10 and overlap with the edge of the solar cell 10.

In this embodiment, light reflection member 30 is disposed over two adjacent solar cells 10 (first solar cell 10A and second solar cell 10B). To be more specific, light reflection member 30 is provided at the edge of first solar cell 10A such that one end of light reflection member 30 in the width direction overlaps with first solar cell 10A. Also, light reflection member 30 is provided at the edge of second solar cell 10B such that the end of light reflection member 30 in the width direction overlaps with second solar cell 10B.

In this embodiment, again, the thickness of light reflection member 30 is larger than that of solar cell 10.

Thus, as illustrated in Fig. 5B, even when one end of light reflection member 30 in the width direction falls off solar cell 10 in a manufacturing process of solar cell module 2 or the like, conductive light reflection film 32 of light reflection member 30 in the fall-off portion is positioned outside the surface of solar cell 10 (on the back protective member 50 side) . Also, there is a case where light reflection member 30 entirely falls off solar cell 10, resulting in a state as illustrated in Fig. 2B. However, even in such a case, conductive light reflection film 32 of light reflection member 30 is positioned outside the surface of solar cell 10.

As described above, in soar cell module 2 according to this embodiment, even when light reflection member 30 falls off solar cell 10, conductive light reflection film 32 of light reflection member 30 in the fall-off portion can be spaced from the surface of solar cell 10. Therefore, generation of a leak current can be avoided. Thus, reliability of solar cell module 2 is improved.

Moreover, in this embodiment, light reflection member 30 is disposed such that the surface of conductive light reflection film 32 faces front protective member 40. However, as illustrated in Fig. 6, light reflection member 30 may be disposed such that the surface of conductive light reflection film 32 faces back protective member 50. In this case, again, the thickness of light reflection member 30 is set larger than that of solar cell 10, and the surface of conductive light reflection film 32 on the solar cell 10 side is positioned outside the surface of solar cell 10. Thus, even if light reflection member 30 falls off solar cell 10, generation of a leak current can be suppressed.

Note that, also for the configurations of light reflection member 30 illustrated in Figs. 5A, 5B and 6, it is that an added distance (d1 + d2) that is a sum of a distance d1 between first solar cell 10A and conductive light reflection film 32 and a distance d2 between second solar cell 10B and conductive light reflection film 32 is 110 µm or more.

Thus, an insulating distance of 110 µm or more is ensured between first solar cell 10A and second solar cell 10B. Accordingly, also for the application of an impulse voltage of 800 V, the generation of the leak current due to breakdown can be surely suppressed.

Note that light reflection member 30 illustrated in Figs. 5A and 5B has conductive light reflection film 32 on the front protective member 40 side. Thus, the material of insulating member 31 may be any of a translucent material such as a transparent material and a non-transparent material such as a white material and a black material. On the other hand, light reflection member 30A illustrated in Fig. 6 has conductive light reflection film 32 on the back protective member 50 side. Thus, the material of insulating member 31 is preferably a translucent material such as a transparent material.

### (Example 3)

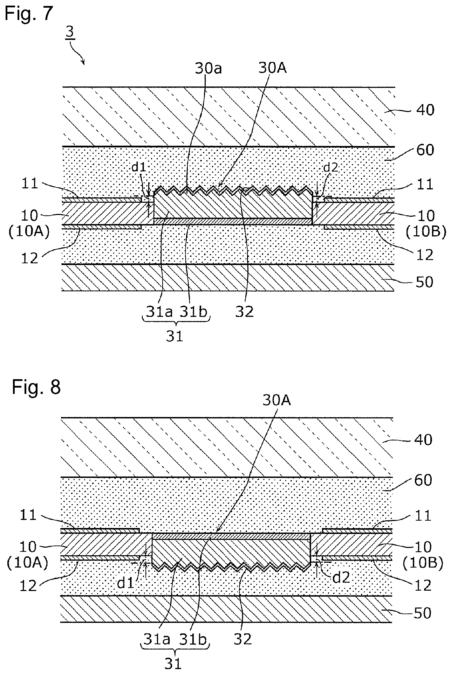

Next, with reference to Fig. 7, solar cell module 3 according to Example 3 is described. Fig. 7 is an enlarged cross-sectional view around a light reflection member in the solar cell module according to Example 3.

As illustrated in Fig. 7, solar cell module 3 according to this embodiment has a configuration in which insulating member 31 has a laminated structure of resin base material 31a and adhesive layer 31b, and conductive light reflection film 32 is formed on the surface of resin base material 31a opposite to the adhesive layer 31b side, in solar cell module 1 according to Example 1 described above.

That is, in this embodiment, light reflection member 30A has a configuration including adhesive layer 31b provided beforehand. To be more specific, light reflection member 30A includes: resin base material 31a; conductive light reflection film 32 formed on one surface of resin base material 31a; and adhesive layer 31b provided on the other surface of resin base material 31a.

Resin base material 31a is made of an insulating resin material such as PET or acrylic, for example. Also, adhesive layer 31b is a resin adhesive made of an insulating resin material such as EVA. In this embodiment, resin base material 31a is a PET sheet, and adhesive layer 31b is a heat-sensitive adhesive or a pressure-sensitive adhesive made of EVA. Note that unevenness 30a is formed on the surface of resin base material 31a. Thus, conductive light reflection film 32 has an uneven surface.

In this embodiment, again, as in the case of Example 1, the thickness of light reflection member 30A is larger than the thickness of solar cell 10, and the surface of conductive light reflection film 32 on the solar cell 10 side is positioned outside the surface of solar cell 10 (on the front protective member 40 side).

Accordingly, conductive light reflection film 32 of light reflection member 30A can be spaced from the surface of solar cell 10. Thus, generation of a leak current can be effectively suppressed. As a result, reliability of solar cell module 1 is improved.

Furthermore, in this embodiment, since light reflection member 30A has adhesive layer 31b, light reflection member 30A can be easily disposed at a predetermined position.

Moreover, in this embodiment, light reflection member 30A is disposed such that the surface of conductive light reflection film 32 faces front protective member 40. However, as illustrated in Fig. 8, light reflection member 30A may be disposed such that the surface of conductive light reflection film 32 faces back protective member 50. In this case, again, the thickness of light reflection member 30A is set larger than that of solar cell 10, and the surface of conductive light reflection film 32 on the solar cell 10 side is positioned outside the surface of solar cell 10 (on the back protective member 50 side). Thus, the generation of the leak current can be suppressed.

Note that it is preferable that the thickness d_{M} of light reflection member 30A illustrated in Figs. 7 and 8 is larger by 55 µm or more than a sum of the thickness dc of solar cell 10 and the height dx of the unevenness of conductive light reflection film 32. Thus, an insulating distance of 110 µm or more can be ensured between adjacent solar cells 10. Accordingly, also for the application of an impulse voltage of 800 V, for example, the generation of the leak current due to breakdown can be effectively suppressed.

Furthermore, it is preferable that an added distance (d1 + d2) that is a sum of a distance d1 between first solar cell 10A and conductive light reflection film 32 and a distance d2 between second solar cell 10B and conductive light reflection film 32 is 110 µm or more. Thus, an insulating distance of 110 µm or more is ensured between first solar cell 10A and second solar cell 10B. Accordingly, also for the application of the impulse voltage described above, the generation of the leak current due to breakdown can be surely suppressed.

Note that light reflection member 30A illustrated in Fig. 7 has conductive light reflection film 32 on the front protective member 40 side. Thus, the materials of resin base material 31a and adhesive layer 31b may be any of a translucent material such as a transparent material and a non-transparent material such as a white material and a black material. On the other hand, light reflection member 30A illustrated in Fig. 8 has conductive light reflection film 32 on the back protective member 50 side. Thus, the materials of resin base material 31a and adhesive layer 31b are preferably a translucent material such as a transparent material.

### (Embodiment 4)

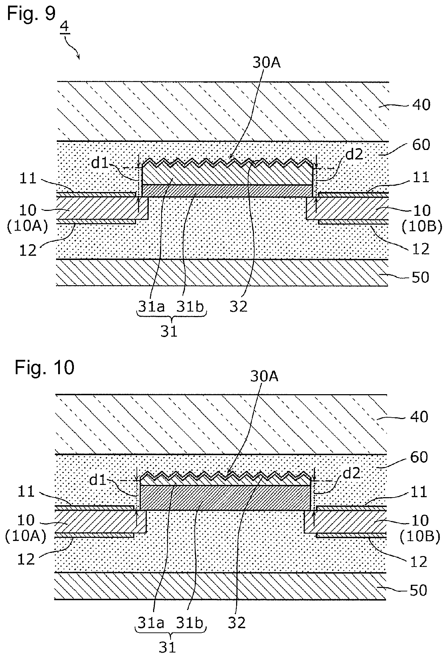

Next, with reference to Fig. 9, solar cell module 4 according to Embodiment 4 is described. Fig. 9 is an enlarged cross-sectional view around a light reflection member in the solar cell module according to Embodiment 4.

As illustrated in Fig. 9, solar cell module 4 according to this embodiment has a configuration in which insulating member 31 has a laminated structure of resin base material 31a and adhesive layer 31b, and conductive light reflection film 32 is formed on the surface of resin base material 31a opposite to the adhesive layer 31b side, in solar cell module 2 according to Embodiment 2 described above.

That is, in this embodiment, as in the case of Example 3, light reflection member 30A includes: resin base material 31a; conductive light reflection film 32 formed on one surface of resin base material 31a; and adhesive layer 31b provided on the other surface of resin base material 31a. Note that materials and structures of resin base material 31a and adhesive layer 31b are the same as those in Example 3.

In this embodiment, again, as in the case of Embodiment 2, the thickness of light reflection member 30A is larger than the thickness of solar cell 10.

Accordingly, even when light reflection member 30 falls off solar cell 10, the surface on the solar cell 10 side of conductive light reflection film 32 of light reflection member 30A in the fall-off portion is positioned outside the surface of solar cell 10 (on the back protective member 50 side). As a result, conductive light reflection film 32 of light reflection member 30 in the fall-off portion can be spaced from the surface of solar cell 10. Therefore, generation of a leak current can be avoided. Thus, reliability of solar cell module 2 is improved.

Furthermore, in this embodiment, since light reflection member 30A has adhesive layer 31b, light reflection member 30A can be easily disposed at the edge of solar cell 10. For example, solar cells 10 can be attached at a predetermined position of light reflection member 30A before string 10S including solar cells 10 connected by tab wiring members 20 is subjected to laminate processing using front-side bonding layer 61 and back-side bonding layer 62. Therefore, light reflection member 30A can be accurately disposed.

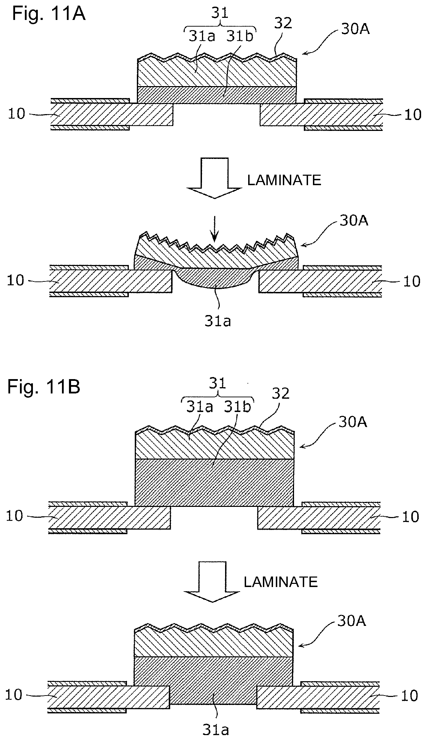

Moreover, in this embodiment, as illustrated in Fig. 10, the thickness of adhesive layer 31b of light reflection member 30A is larger than the thickness of solar cell 10. Thus, curvature in light reflection member 30A can be suppressed. This point is described in detail with reference to Figs. 11A and 11B. Fig. 11A is an enlarged cross-sectional view around a light reflection member in the solar cell module according to Embodiment 4 illustrated in Fig. 9. Fig. 11B is an enlarged cross-sectional view around a light reflection member in a solar cell module according to Modified Example 1 of Embodiment 4 illustrated in Fig. 10.

As described above, laminate processing is performed after strings 10S are formed by connecting solar cells 10 with tab wiring members 20. That is, strings 10S having light reflection member 30A disposed on solar cells 10 are sandwiched between front-side bonding layer 61 and back-side bonding layer 62 and between front protective member 40 and back protective member 50, and then thermocompression bonding is performed. The thermocompression bonding during the laminate processing in this event causes light reflection member 30A to be pressurized from front-side bonding layer 61 and back-side bonding layer 62.

In this case, as illustrated in Fig. 11A, when the thickness of adhesive layer 31b of light reflection member 30A is less than the thickness of solar cell 10, the pressing force during the laminate processing may cause light reflection member 30A to be curved so as to protrude toward the gap between two adjacent solar cells 10. When light reflection member 30A is curved, light entering light reflection member 30A cannot be guided to a desired spot on solar cell 10. As a result, a desired effect of improving power generation efficiency by disposing light reflection member 30A cannot be achieved.

On the other hand, as illustrated in Fig. 11B, when the thickness of adhesive layer 31b of light reflection member 30A is not less than the thickness of solar cell 10, the curvature in light reflection member 30A can be suppressed even if a pressure is applied onto light reflection member 30A during the laminate processing. Thus, the light entering light reflection member 30A can be reflected and guided to a desired spot on solar cell 10. As a result, the desired effect of improving the power generation efficiency by disposing light reflection member 30A can be achieved.

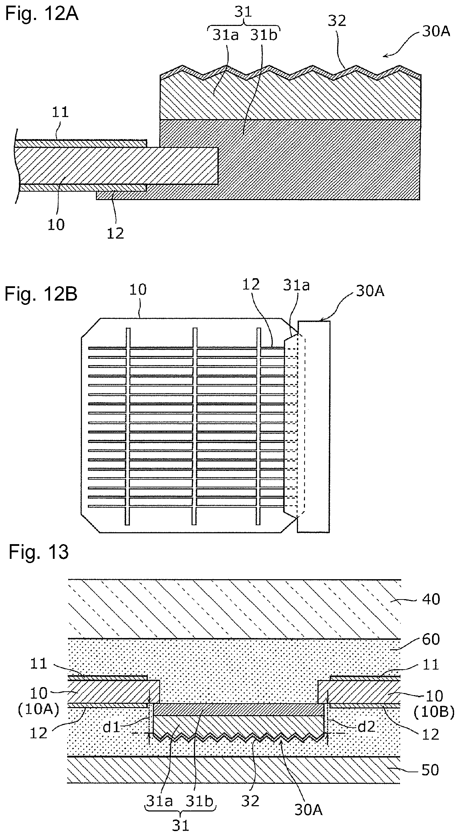

Moreover, by setting the thickness of adhesive layer 31b of light reflection member 30A to be larger than the thickness of solar cell 10, back-side collector electrode 12 in solar cell 10 can be partially covered with adhesive layer 31b. Thus, peeling-off of back-side collector electrode 12 can be suppressed. This point is described in detail with reference to Figs. 12A and 12B. Fig. 12A is a partially enlarged cross-sectional view of another aspect of the solar cell module according to Modified Example 1 of Embodiment 4 illustrated in Fig. 10. Fig. 12B is a partially enlarged back view of the same solar cell module illustrated in Fig. 12A.

As illustrated in Figs. 12A and 12B, when the thickness of adhesive layer 31b of light reflection member 30A is not less than the thickness of solar cell 10, the pressing force during the laminate processing can cause adhesive layer 31b of light reflection member 30A to run around solar cell 10 to the back surface (the surface opposite to the surface where light reflection member 30A is firstly provided) of solar cell 10. Thus, back-side collector electrode 12 provided on the back surface of solar cell 10 can be partially covered with adhesive layer 31b running around solar cell 10 to the back surface of solar cell 10. To be more specific, edges of finger electrodes in back-side collector electrode 12 are covered with adhesive layer 31b. As a result, the edges of back-side collector electrode 12 can be held by adhesive layer 31b. Thus, peeling-off of the edges of the finger electrodes in back-side collector electrode 12 can be suppressed.

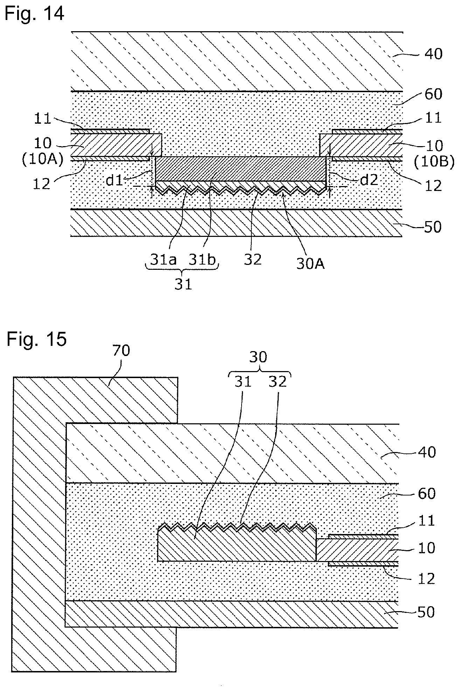

Moreover, in this embodiment, as illustrated in Figs. 9 and 10, light reflection member 30A is disposed such that the surface of conductive light reflection film 32 faces front protective member 40. However, as illustrated in Figs. 13 and 14, light reflection member 30A may be disposed such that the surface of conductive light reflection film 32 faces back protective member 50. In this case, again, the thickness of light reflection member 30A is set larger than that of solar cell 10, and the surface of conductive light reflection film 32 on the solar cell 10 side is positioned outside the surface of solar cell 10. Thus, generation of a leak current can be suppressed when light reflection member 30A falls off solar cell 10.

Note that, also for the configurations of light reflection member 30A illustrated in Figs. 9, 10, 13 and 14, it is that an added distance (d1 + d2) that is a sum of a distance d1 between first solar cell 10A and conductive light reflection film 32 and a distance d2 between second solar cell 10B and conductive light reflection film 32 is 110 µm or more.

Thus, an insulating distance of 110 µm or more is ensured between first solar cell 10A and second solar cell 10B. Accordingly, also for the application of an impulse voltage of breakdown can be surely suppressed.

Note that light reflection member 30A illustrated in Figs. 9 and 10 has conductive light reflection film 32 on the front protective member 40 side. Thus, the materials of resin base material 31a and adhesive layer 31b may be any of a translucent material such as a transparent material and a non-transparent material such as a white material and a black material. On the other hand, light reflection member 30A illustrated in Figs. 13 and 14 has conductive light reflection film 32 on the back protective member 50 side. Thus, the materials of resin base material 31a and adhesive layer 31b are preferably a translucent material such as a transparent material.

### (Modified Example and the like)

Although the solar cell modules are described above based on Embodiments 1 to 4, the invention is not limited to Embodiments 1 to 4 described above.

For example, in the above embodiments, the description is given of the example where light reflection members 30 and 30A are disposed between two adjacent solar cells 10. As another configuration example, light reflection members 30 and 30A may be disposed adjacent to the outermost solar cell 10 adjacent to frame 70, as illustrated in Fig. 15. In this case, again, light reflection member 30 may be disposed upside down or may be disposed so as to overlap with the edge on the front or back surface of solar cell 10.

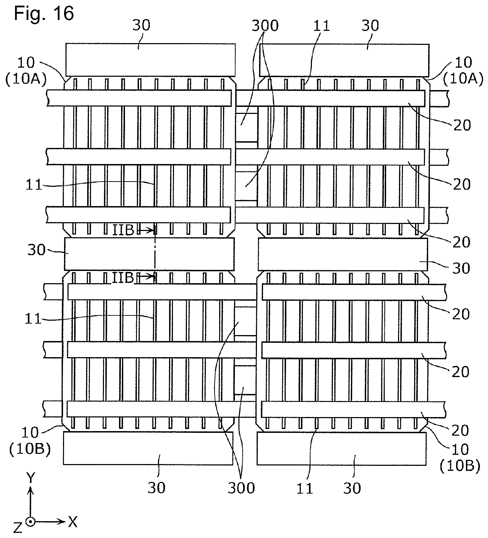

Moreover, in the above embodiments, light reflection members 30 and 30A are disposed in the gap between two adjacent strings 10S. However, the invention is not limited thereto. For example, as illustrated in Fig. 16, light reflection member 300 may be disposed in a gap between two adjacent solar cells 10 within string 10S.

Moreover, in the above embodiments, light reflection members 30 and 30A are provided for all solar cells 10. However, light reflection members 30 and 30A may be provided for only some 10. However, light reflection members 30 and 30A may be provided for only some of solar cells 10. That is, there may be solar cells where light reflection member 30 is not provided.

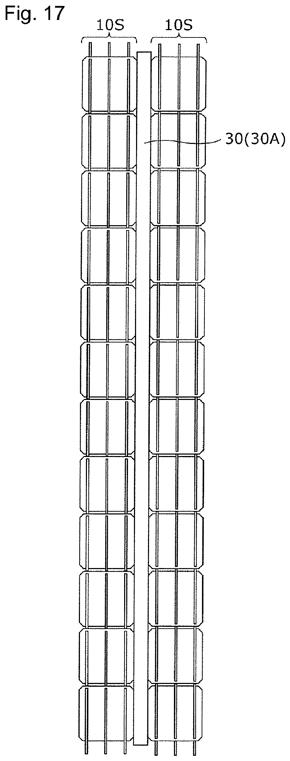

Moreover, in the above embodiments and examples, light reflection members 30 and 30A are provided in every gap between solar cells 10 adjacent to each other along the longitudinal direction of string 10S in the gap between two adjacent strings 10S. However, the invention is not limited thereto. For example, light reflection members 30 and 30A may be provided over solar cells 10 along the longitudinal direction of string 10S in the gap between two adjacent strings 10S. As an example, as illustrated in Fig. 17, light reflection members 30 and 30A may be one elongated light reflection sheet across the entire string 10S.

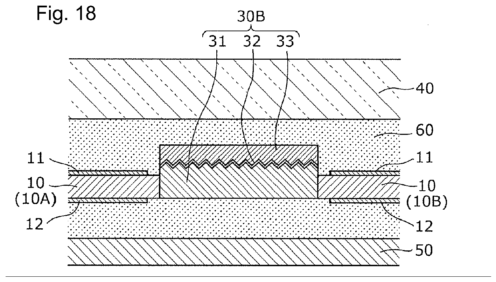

Moreover, in the above embodiments and examples, conductive light reflection film 32 is formed on the top surface of light reflection members 30 and 30A. However, the invention is not limited thereto. For example, as illustrated in Fig. 18, light reflection member 30B may have a configuration in which insulating member 33 (second insulating member) is further formed on conductive light reflection film 32 formed on insulating member 31 (first insulating member). In this case, a translucent material needs to be used as the material of insulating member 33. For example, insulating member 33 may be a transparent member made of a transparent resin material.

Moreover, in the above embodiments and examples, the number of light reflection members 30 and 30A provided in the gap between two adjacent solar cells 10 may be two or more rather than one.

Moreover, in the above embodiments and examples, the semiconductor substrate in solar cell 10 is the n-type semiconductor substrate. However, the semiconductor substrate may be a p-type semiconductor substrate.

Moreover, in the above embodiments and examples, the solar cell module is of the single-sided light receiving type, back protective member 50 serve as the light-receiving surfaces.

Moreover, in the above embodiments, the semiconductor material of the photoelectric converter in solar cell 10 is silicon. However, the invention is not limited thereto. As the semiconductor material of the photoelectric converter in solar cell 10, gallium arsenide (GaAs), indium phosphide (InP) or the like may be used.

## Claims

1. A solar cell module (2, 4) comprising:
a first solar cell (10, 10A);
a second solar cell (10, 10B) disposed with a gap from the first solar cell (10, 10A) in a first direction,
wherein each of the first and second solar cells (10, 10A, 10B) includes a photoelectric conversion body with a front-side collector electrode (11) and a back-side collector electrode (12) each of which is formed of conductive paste;
a light reflection member (30, 30A, 30B, 300) provided between the first solar cell (10, 10A) and the second solar cell (10, 10B) in the first direction orthogonal to a thickness direction of the first solar cell (10, 10A),
a front protective member (40) and a back protective member (50),
a front-side bonding layer (61) and a back-side bonding layer (62), wherein the first and second solar cells (10, 10A, 10B) and the light reflection member (30, 30A, 30B, 3000) are sandwiched between the front-side bonding layer (61) and the backside bonding layer (62) between the front protective member (40) and the back protective member (50), wherein
the light reflection member (30, 30A, 30B, 300) includes an insulating member (31) and a conductive light reflection film (32) on the insulating member (31) in the thickness direction, wherein the light reflection member (30, 30A, 30B, 300) does not electrically connect the first solar cell (10A) and the second solar cell (10B),
a thickness of the light reflection member (30, 30A, 30B, 300) is larger than a thickness of the first solar cell (10, 10A) in the thickness direction,
the conductive light reflection film (32) is positioned outside the first solar cell (10, 10A) in the thickness direction, wherein one end of the light reflection member (30, 30A, 30B, 300) overlaps as seen in the thickness direction with an edge of one of a front or back surface of the first solar cell (10, 10A) in such a manner that the one end of the light reflection member (30, 30A, 30B, 300) is in direct contact with the edge of the one of front or back surface of the first solar cell (10, 10A) in the thickness direction, and
wherein the insulating member (31) has a multi-layer structure including a resin base material (31a) and an adhesive layer (31b), and
the conductive light reflection film (32) is formed on the resin base material (31a) on the adhesive layer (31b),
wherein a thickness of the adhesive layer (31b) is larger than the thickness of the first solar cell (10, 10A).

2. The solar cell module (2, 4) according to claim 1, wherein the light reflection member (30, 30A, 30B, 300) bridges between the first solar cell (10, 10A) and the second solar cell (10, 10B).

3. The solar cell module (2, 4) according to claim 1 or 2, wherein
the collector electrodes (11, 12) are provided on both surfaces of the first solar cell (10, 10A), wherein the both surfaces include a first surface and a second surface provided on an opposite side of the first solar cell (10, 10A), the first surface being closer to the conductive light reflection film (32) than the second surface, and
the adhesive layer (31b) runs around the first solar cell (10, 10A) from the first surface to the second surface, and covers a part of the collector electrode provided on the second surface.

4. The solar cell module (2, 4) according to claim 1 or 2, wherein
a surface of the insulating member (31a) facing the conductive light reflection film (32) has an uneven surface shape,
a surface of the conductive light reflection film (32) has an uneven surface shape along with the uneven surface of the insulating member (31), and
the thickness of the light reflection member (30, 30A, 30B, 300) is larger by 55 µm or more than a sum of the thickness of the first solar cell (10, 10A) and a height of the uneven surface shape of the conductive light reflection film (32) .

## Patentansprüche

1. Solarzellenmodul (2, 4) mit:
einer ersten Solarzelle (10, 10A),
einer zweiten Solarzelle (10, 10B), die mit einem Abstand von der ersten Solarzelle (10, 10A) in einer ersten Richtung angeordnet ist,
wobei jede der ersten und zweiten Solarzelle (10, 10A, 10B) einen photoelektrischen Wandlerkörper mit einer vorderseitigen Kollektorelektrode (11) und einer rückseitigen Kollektorelektrode (12) aufweist, die jeweils aus leitender Paste gebildet sind,
einem Lichtreflexionselement (30, 30A, 30B, 300), das zwischen der ersten Solarzelle (10, 10A) und der zweiten Solarzelle (10, 10B) in der ersten Richtung rechtwinklig zu einer Dickenrichtung der ersten Solarzelle (10, 10A) vorgesehen ist,
einem vorderen Schutzelement (40) und einem hinteren Schutzelement (50),
einer Vorderseiten-Verbindungsschicht (61) und einer Rückseiten-Verbindungsschicht (62), wobei die erste und die zweite Solarzelle (10, 10A, 10B) und das Lichtreflexionselement (30, 30A, 30B, 3000) zwischen der Vorderseiten-Verbindungsschicht (61) und der Rückseiten-Verbindungsschicht (62) zwischen dem vorderen Schutzelement (40) und dem hinteren Schutzelement (50) sandwichartig angeordnet sind, wobei
das Lichtreflexionselement (30, 30A, 30B, 300) ein Isolierelement (31) und einen leitfähigen Lichtreflexionsfilm (32) auf dem Isolierelement (31) in der Dickenrichtung aufweist, wobei das Lichtreflexionselement (30, 30A, 30B, 300) die erste Solarzelle (10A) und die zweite Solarzelle (10B) nicht elektrisch verbindet,
eine Dicke des Lichtreflexionselements (30, 30A, 30B, 300) größer ist als eine Dicke der ersten Solarzelle (10, 10A) in der Dickenrichtung,
der leitende Lichtreflexionsfilm (32) außerhalb der ersten Solarzelle (10, 10A) in der Dickenrichtung positioniert ist, wobei ein Ende des Lichtreflexionselements (30, 30A, 30B, 300) mit einer Kante einer Vorder- oder Rückfläche der ersten Solarzelle (10, 10A) derart in der Dickenrichtung gesehen überlappt, dass das eine Ende des Lichtreflexionselements (30, 30A, 30B, 300) in direktem Kontakt mit der Kante der Vorder- oder Rückfläche der ersten Solarzelle (10, 10A) in der Dickenrichtung steht, und
wobei das Isolierelement (31) eine Mehrschichtstruktur mit einem Harzgrundmaterial (31a) und einer Klebeschicht (31b) aufweist, und
der leitende Lichtreflexionsfilm (32) auf dem Harzgrundmaterial (31a) auf der Klebeschicht (31b) ausgebildet ist,
wobei eine Dicke der Klebeschicht (31b) größer als die Dicke der ersten Solarzelle (10, 10A) ist.

2. Solarzellenmodul (2, 4) nach Anspruch 1, wobei
das Lichtreflexionselement (30, 30A, 30B, 300) Brücken zwischen der ersten Solarzelle (10, 10A) und der zweiten Solarzelle (10, 10B) bildet.

3. Solarzellenmodul (2, 4) nach Anspruch 1 oder 2, wobei die Kollektorelektroden (11, 12) auf beiden Oberflächen der ersten Solarzelle (10, 10A) vorgesehen sind, wobei die beiden Oberflächen eine erste Oberfläche und eine zweite Oberfläche umfassen, die auf einer gegenüberliegenden Seite der ersten Solarzelle (10, 10A) vorgesehen ist, wobei die erste Oberfläche näher an dem leitfähigen Lichtreflexionsfilm (32) liegt als die zweite Oberfläche, und
die Klebeschicht (31b) um die erste Solarzelle (10, 10A) von der ersten Oberfläche zur zweiten Oberfläche verläuft und einen Teil der auf der zweiten Oberfläche vorgesehenen Kollektorelektrode bedeckt.

4. Solarzellenmodul (2, 4) nach Anspruch 1 oder 2, wobei eine Oberfläche des Isolierelements (31a), die dem leitenden Lichtreflexionsfilm (32) zugewandt ist, eine ungleichmäßige Oberflächenform aufweist,
eine Oberfläche des leitfähigen Lichtreflexionsfilms (32) zusammen mit der unebenen Oberfläche des Isolierelements (31) eine unebene Oberflächenform aufweist, und
die Dicke des Lichtreflexionselements (30, 30A, 30B, 300) um 55 µm oder mehr als die Summe der Dicke der ersten Solarzelle (10, 10A) und einer Höhe der unebenen Oberflächenform des leitfähigen Lichtreflexionsfilms (32) größer ist.

## Revendications

1. Module de cellule solaire (2, 4) comprenant :
une première cellule solaire (10, 10A) ;
une deuxième cellule solaire (10, 10B) disposée avec un écart par rapport à la première cellule solaire (10, 10A) dans une première direction,
dans lequel chacune des première et deuxième cellules solaires (10, 10A, 10B) comporte un corps de conversion photoélectrique avec une électrode collectrice côté avant (11) et une électrode collectrice côté arrière (12), chacune desquelles est formée d'une pâte conductrice ;
un organe de réflexion de lumière (30, 30A, 30B, 300) prévu entre la première cellule solaire (10, 10A) et la deuxième cellule solaire (10, 10B) dans la première direction orthogonale à une direction d'épaisseur de la première cellule solaire (10, 10A),
un organe de protection avant (40) et un organe de protection arrière (50),
une couche de liaison côté avant (61) et une couche de liaison côté arrière (62), dans lequel les première et deuxième cellules solaires (10, 10A, 10B) et l'organe de réflexion de lumière (30, 30A, 30B, 3000) sont pris entre la couche de liaison côté avant (61) et la couche de liaison côté arrière (62) entre l'organe de protection avant (40) et l'organe de protection arrière (50), dans lequel
l'organe de réflexion de lumière (30, 30A, 30B, 300) comporte un organe isolant (31) et un film conducteur de réflexion de lumière (32) sur l'organe isolant (31) dans la direction de l'épaisseur, dans lequel l'organe de réflexion de lumière (30, 30A, 30B, 300) ne connecte pas électriquement la première cellule solaire (10A) et la deuxième cellule solaire (10B),
une épaisseur de l'organe de réflexion de lumière (30, 30A, 30B, 300) est supérieure à une épaisseur de la première cellule solaire (10, 10A) dans la direction de l'épaisseur,
le film conducteur de réflexion de lumière (32) est positionné à l'extérieur de la première cellule solaire (10, 10A) dans la direction de l'épaisseur, dans lequel une extrémité de l'organe de réflexion de lumière (30, 30A, 30B, 300) se chevauche comme vu dans la direction de l'épaisseur avec un bord de l'une parmi une surface avant ou arrière de la première cellule solaire (10, 10A) de telle manière que l'une extrémité de l'organe de réflexion de lumière (30, 30A, 30B, 300) soit en contact direct avec le bord de l'une parmi la surface avant ou arrière de la première cellule solaire (10, 10A) dans la direction de l'épaisseur, et
dans lequel l'organe isolant (31) possède une structure multicouche comportant un matériau de base en résine (31a) et une couche adhésive (31b), et
le film conducteur de réflexion de lumière (32) est formé sur le matériau de base en résine (31a) sur la couche adhésive (31b),
dans lequel une épaisseur de la couche adhésive (31b) est plus large que l'épaisseur de la première cellule solaire (10, 10A) .

2. Module de cellule solaire (2, 4) selon la revendication 1, dans lequel l'organe de réflexion de lumière (30, 30A, 30B, 300) fait le pont entre la première cellule solaire (10, 10A) et la deuxième cellule solaire (10, 10B).

3. Module de cellule solaire (2, 4) selon la revendication 1 ou 2, dans lequel
les électrodes collectrices (11, 12) sont prévues sur les deux surfaces de la première cellule solaire (10, 10A), dans lequel les deux surfaces comportent une première surface et une deuxième surface prévues sur un côté opposé de la première cellule solaire (10, 10A), la première surface étant plus proche du film conducteur de réflexion de lumière (32) que la deuxième surface, et
la couche adhésive (31b) entoure la première cellule solaire (10, 10A) de la première surface à la deuxième surface, et recouvre une partie de l'électrode collectrice prévue sur la deuxième surface.

4. Module de cellule solaire (2, 4) selon la revendication 1 ou 2, dans lequel
une surface de l'organe isolant (31a) faisant face au film conducteur de réflexion de lumière (32) possède une forme de surface irrégulière,
une surface du film conducteur de réflexion de lumière (32) possède une forme de surface irrégulière avec la surface irrégulière de l'organe isolant (31), et
l'épaisseur de l'organe de réflexion de lumière (30, 30A, 30B, 300) est plus large de 55 µm ou supérieure à la somme de l'épaisseur de la première cellule solaire (10, 10A) et d'une hauteur de la forme de surface irrégulière du film conducteur de réflexion de lumière (32).
